# EUROPEAN PATENT SPECIFICATION

(11) **EP 2 091 307 B1**
(45) Date of publication and mention of the grant of the patent: **19.10.2011**
(21) Application number: 06823428.5
(22) Date of filing: 15.11.2006
(51) Int. Cl.: H05K 3/36, H05K 1/14, H05K 3/28

(54) **CIRCUIT BOARD CONNECTION STRUCTURE AND CIRCUIT BOARD**
LEITERPLATTENVERBINDUNGSSTRUKTUR UND LEITERPLATTE
STRUCTURE DE CONNEXION DE CARTE DE CIRCUIT IMPRIMÉ ET CARTE DE CIRCUIT IMPRIMÉ

(43) Date of publication of application: 19.08.2009
(73) Proprietor: Panasonic Corporation, Kadoma-shi Osaka 571-8501 (JP)
(72) Inventor: SUZUKI, Hiroyuki, Osaka 540-6207 (JP)
(74) Representative: Grünecker, Kinkeldey, Stockmair & Schwanhäusser
(86) International application number: PCT/JP2006/322780
(87) International publication number: WO 2008/059571

(56) References cited:
- EP-A1- 1 545 170
- EP-A1- 1 951 010
- JP-A- 62 046 589
- JP-A- 2001 156 416
- JP-A- 2004 096 049
- JP-A- 2004 212 587
- JP-A- 2006 237 158
- US-A1- 2003 213 963

## Description

### Technical Field

The present invention relates to a circuit board in which a circuit pattern is formed on a surface of a base member and a protection layer is laminated in such a manner that a connecting portion provided at an end portion of the circuit pattern is exposed and a circuit board connection structure in which such circuit boards are connected together via an anisotropic conductive adhesive.

### Background Art

The circuit board connection structure is such that a first connecting portion of a first circuit board and a second connecting portion of a second circuit board are disposed so as to confront each other via an anisotropic conductive adhesive and the anisotropic conductive adhesive is melted and is then set by applying a pressure to a first base member and a second base member in a direction in which the first base member and the second base member approach each other along their thickness direction while being heated by a pair of pressure-applying jigs, whereby not only is an electrical conduction ensured between the first connecting portion and the second connecting portion, but also the first base member and the second base member are fixed to each other.

Incidentally, in this circuit board connection structure, it is considered that the anisotropic conductive adhesive comes out of the jigs to be set at normal temperatures, and the anisotropic conductive adhesive so set forms a dam to hold back the anisotropic conductive adhesive coming out thereafter, whereby a smooth discharge of a redundant portion of the anisotropic conductive adhesive is disrupted.
In addition, it is considered that protection layers are laminated on the first circuit board and the second circuit board to protect circuit patterns other than the connecting portions and end faces of edge portions of the protection layers which configure boundaries relative to the connecting portions form a dam to disrupt the discharge of the redundant anisotropic adhesive.

A defective is produced in which no electrical conduction can be ensured due to the discharge of the anisotropic conductive adhesive being disrupted in the way described above, and repair work is applied to such a defective in which the anisotropic conductive adhesive is softened by heating the portion where the first connecting portion and the second connecting portion are connected together, the first base member and the second material are then pulled part from each other, the anisotropic conductive adhesive which remains so as to cover the first connecting portion and the second connecting portion is removed by a solvent or spatula, and the first circuit board and the second circuit board are then connected together again by following the aforesaid connecting steps.

However, since such repair work needs to be performed after the remaining anisotropic conductive adhesive has been removed, the repair work is complicated and troublesome, and there is caused a fear that the circuit pattern at the first connecting portion and the circuit pattern at the second connecting portion may be damaged, thus, improvements having been required.
To meet a request like this, there have been proposed a substrate terminal connection structure and connecting method for discharging a redundant portion of an adhesive by insulation holes provided in a base member (for example, Patent Document 1).
Patent Document 1: JP-A-11-54876

US2003/0213963A1 discloses an electronic interconnection comprising conductors with tapered end portions to interconnect electronic devices, the conductors being formed on a detachable substrate. The substrate is lined with a package containing electronic devices. The conductors are bonded to pads on the devices. Then, the substrate is detached. Each conductor is self-supporting between the devices, has a surface that is substantially parallel to the surface of the pads and has tapered end portions to be connected to the pads.

EP1951010A1 being a document according to Art. 54(3) EPC discloses a circuit board connecting structure enabled to obtain the reliable connection between circuit patterns by restricting the elongation of a flexible base material even when connecting portions are arranged in a face-to-face configuration and are press contacted with each other. The described circuit board connecting structure includes a first circuit board, and a second circuit board. The circuit board connecting structure is configured so when the first connecting portion and a second connecting portion are sandwiched by a pair of pressing jigs and are press-contacted with each other, one of first outer dummy terminals is accommodated between columns of ones of second outer dummy terminals, while the other first outer dummy terminal is accommodated between columns of the other ones of the second outer dummy terminals.

JP2006-237158 discloses a circuit board with connection terminals having substantially parallel first and second wiring patterns and end terminals of two different widths, whereby the terminals are connected together by an anisotropic conductive film.

### Problem that the Invention is to Solve

Incidentally, in Patent Document 1, although the redundant portion of the adhesive is discharged to a back side of the base member by the insulation holes provided in the insulation holes provided in the base member, it is considered depending upon situations that there may occur a case where the adhesive is discharged too much, leading to a lack of adhesive.

The invention has been made with a view to solving the problem, and an object thereof is to provide a circuit board connection structure and a circuit board in which a redundant portion of an anisotropic conductive adhesive between connecting portions which are disposed so as to confront each other can be discharged smoothly and accurately.

### Means for Solving the Problem

A circuit board connection structure of the invention is a circuit board connection structure comprising the features of claim 2.

A circuit board of the invention is a circuit board comprising the features of claim 1.

In such invention, since at least either the first end portion of the first wiring pattern or the second end portion of the first wiring pattern is formed so as to be tapered in the direction towards the other, a gap between the first wiring pattern and the second wiring pattern which lie adjacent to each other expands step by step or continuously towards the first end portion of the first wiring pattern or the second end portion of the first wiring pattern so as to form the discharge space.
Consequently, in the invention, only a redundant portion of the anisotropic conductive adhesive is discharged smoothly to the first end portion side of the first wiring pattern and the second end portion side of the second wiring pattern, whereby the (first) connecting portion and the (second) connecting portion can be connected together well.

### Advantage of the Invention

According to the circuit board connection structure and the circuit board, by forming the discharge space for discharging the anisotropic conductive adhesive, there is provided the advantage that the redundant portion of the anisotropic conductive adhesive between the connecting portions which are disposed so as to confront each other can be discharged to the discharge space smoothly and accurately

### Brief Description of the Drawings

Fig. 1 is a perspective view depicting a circuit board connection structure according to a first illustrative example not forming a part of the invention.
Fig. 2 is a perspective view depicting circuit patterns of the circuit board connection structure according to the first illustrative example not forming a part of the invention.
Fig. 3 is an exploded perspective view depicting the circuit board connection structure according to the first illustrative example not forming a part of the invention.
Fig. 4 is a diagram illustrating flows of anisotropic conductive adhesive according to the first illustrative example not forming a part of the invention.
Fig. 5 is a plan view illustrating a modified example of the first illustrative example not forming a part of the invention.
Fig. 6 is a perspective view depicting a circuit board connection structure according to a second illustrative example not forming a part of the invention.
Fig. 7 is a plan view illustrating the circuit board connection structure according to the second illustrative example not forming a part of the invention.
Fig. 8 is a perspective view depicting a circuit board connection structure according to the invention.
Fig. 9 is a plan view illustrating the circuit board connection structure according to the invention.
Fig. 10 is a plan view depicting a modified example to the circuit board connection structure according to the invention.

### Description of Reference Numerals

10, 40, 60 circuit board connection structure; 11, 41, 61, 70 first circuit board (circuit board); 12, 43, 64 second circuit board (circuit board); 13 first connecting portion (connecting portion); 14 second connecting portion (connecting portion); 16 anisotropic conductive adhesive; 17 first base member (base member); 17A surface of first base member, 18, 62, 71 first circuit pattern (circuit pattern); 19, 63, 72 first wiring pattern of first base member, 19A, 63A, 72A first end portion of first wiring pattern of first base member; 19B, 63B, 72B second end portion of first wiring pattern of first base member, 20 first protection layer (protection layer); 20A, 21A edge portion; 21 second protection layer, 22 second base member (base member); 22A surface of second base member, 23, 65 second circuit pattern (circuit pattern); 24, 66 first wiring pattern of second base member; 24A, 66A first end portion of first wiring pattern of second base member, 24B, 66B second end portion of first wiring pattern of second base member; 26, 28, 45, 51 line connecting end portions together, 39, 83, 93 second wiring pattern of first base member, 39A, 83A, 93A first end portion of second wiring pattern of first base member; 39B, 838, 93B second end portion of second wiring pattern of first base member; 42 first via (via); 44 second via (via); 49, 84 second wiring pattern of second base member, 49A, 84A first end portion of second wiring pattern of second base member; 49B, 84B second end portion of second wiring pattern of second base member, 80 first protection area; 81 second protection area.

### Best Mode for Carrying out the Invention

Hereinafter, a circuit board connection structure and a circuit board according to a first illustrative example not forming a part of the invention will be described by reference to the drawings.
As is shown in Figs . 1 to 3, a circuit board connection structure 10 according to a first illustrative example includes a first circuit board (a circuit board) 11 and a second circuit board 12, and a first connecting portion 13 of the first circuit board 11 and a second connecting portion 14 of the second circuit board (the circuit board) 12 are disposed so as to confront each other, so as to be connected together via an anisotropic conductive adhesive.

The first circuit board 11 is made up of a first circuit pattern (a circuit pattern) 18 which extends on a surface 17A of a first base member (a base member) 17, a first projection area 80 in which the first circuit pattern 18 is covered with a first protection layer 20, and a first connecting portion (a connecting portion) 13A where the first circuit pattern 18 is exposed and which has a connecting end portion of the first circuit pattern 18.

The first circuit pattern 18 is made up of first wiring patterns 19 of the first base member which extend on the surface 17A of the first base member 17 and second wiring patterns 39 which extend substantially parallel to the first wiring patterns 19 of the first base member on the surface 17A of the first base member.

The first wiring patterns 19 of the first base member and the second wiring patterns 39 of the first base member are arranged alternately along an arranging direction which extends along width directions of the first wiring patterns 19 of the first base member and the second wiring patterns 39 of the first base member, that is, a direction (an A-B direction indicated by arrows A, B) which is at right angles to a direction in which the first wiring patterns 19 of the first base member extend or a direction in which the second wiring patterns 39 of the first base member extend.
The first wiring patterns 19 of the first base member are formed longer than the second wiring patterns 39 of the first base member in a direction in which they extend.

The first protection area 80 is an area where the first protection layer 20 is laminated on the first wiring patterns 19 of the first base member and the second wiring patterns 39 of the first base member.
The first wiring patterns 19 of the first base member and the second wiring patterns 39 of the first base member are exposed at the first connecting portion 13.

The first connecting portion 13 has first end portions 19A of the first wiring patterns 19 of the first base member which are distal end portions in the direction in which the first wiring patterns 19 of the first base member extend and first end portions 39A of the second wiring patterns 39 of the first base member which are distal end portions in the direction in which the second wiring patterns 39 of the first base member extend.
The first end portions 19A of the first wiring patterns 19 of the first base member and the first end portions 39A of the second wiring patterns 39 of the first base member configure the connecting end portion of the first circuit pattern 18.

The second circuit board 12 is made up of a second circuit pattern (a circuit pattern) 23 which extends on a surface 22A of a second base member (a base member) 22, a second protection area 81 where the second circuit pattern 23 is covered with a second protection layer 21 and a second connecting portion (a connecting portion) 14A where the second circuit pattern 23 is exposed and which has a connecting end portion of the second circuit pattern 23.

The second circuit pattern 23 is made up of first wiring patterns 24 of a second base member which extends on a surface 22A of the second base member 22 and second wiring patterns 49 of the second base member which extend substantially parallel to the first wiring patterns 24 of the second base member on the surface 22A of the second base member 22.

The first wiring patterns 24 of the second base member and the second wiring patterns 49 of the second base member are arranged alternately along an arranging direction which extends along width directions of the first wiring patterns 24 of the second base member and the second wiring patterns 49 of the second base member, that is, a direction (an A-B direction indicated by arrows A, B) which is at right angles to a direction in which the first wiring patterns 29 of the second base member extend or a direction in which the second wiring patterns 49 of the second base member extend.
The first wiring patterns 29 of the second base member are formed longer than the second wiring patterns 49 of the second base member in a direction in which they extend.

The second protection area 81 is an area where the second protection layer 21 is laminated on the first wiring patterns 24 of the second base member and the second wiring patterns 49 of the second base member.
The first wiring patterns 24 of the second base member and the second wiring patterns 49 of the second base member are exposed at the second connecting portion 14.

The second connecting portion 14 has first end portions 24A of the first wiring patterns of the second base member which are distal end portions in the direction in which the first wiring patterns 24 of the second base member extend and first end portions 49A of the second wiring patterns 49 of the second base member which are distal end portions in the direction in which the second wiring patterns 49 of the second base member extend.
The first end portions 24A of the first wiring patterns 24 of the second base member and the first end portions 49A of the second wiring patterns 49 of the second base member configure the connecting end portion of the second circuit pattern 23.

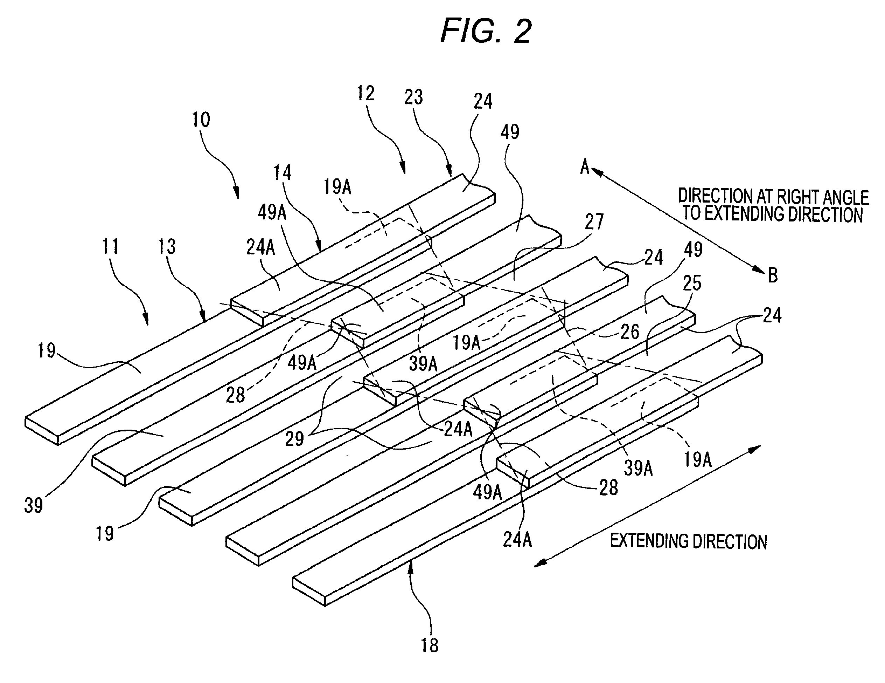

In this circuit board connection structure 10, the first connecting portion 13 of the first circuit board 11 and the second connecting portion 14 of the second circuit board 12 are disposed so as to confront each other via an anisotropic conductive adhesive 16, the first wiring patterns 19 of the first base member of the first connecting portion 13 and the first wiring patterns 24 of the second base member of the second connecting portion 14 are connected together, and the second wiring patterns 39 of the first base member of the first connecting portion 13 and the second wiring patterns 49 of the second base member of the second connecting portion 14 are connected together.
Further, as is shown in Fig. 2, in this circuit board connection structure 10, lines 26 which connect the first end portions 19A of the first wiring patterns of the first base member with the first end portions 39A of the second wiring patterns of the first base member are made to intersect the direction in which the first wiring patterns 19 of the first base member extend or the direction in which the second wiring patterns 19 of the first base member extend at a predetermined angle other than a right angle.

Namely, by the first end portions 19A of the first wiring patterns of the first base member being located in positions which project further than positions where the first end portions 39A of the second wiring patterns of the first base member are located, a side of the first circuit board 11 which lies to face the first end portions 19A of the first wiring patterns of the first base member and the first end portions 39A of the second wiring patterns of the first base member is disposed into an irregular shape.

In addition, in this circuit board connection structure 10, lines 28 which connect the first end portions 24A of the first wiring patterns of the second base member with the first end portions 49A of the second wiring patterns of the second base member are made to intersect the direction in which the first wiring patterns 24 of the second base member extend or the direction in which the second wiring patterns 49 of the second base member extend at a predetermined angle other than a right angle.

Namely, by the first end portions 24A of the first wiring patterns of the second base member being located in positions which project further than positions where the first end portions 49A of the second wiring patterns of the second base member are located, a side of the second circuit board 12 which lies to face the first end portions 24A of the first wiring patterns of the second base member and the first end portions 49A of the second wiring patterns of the second base member is disposed into an irregular shape.

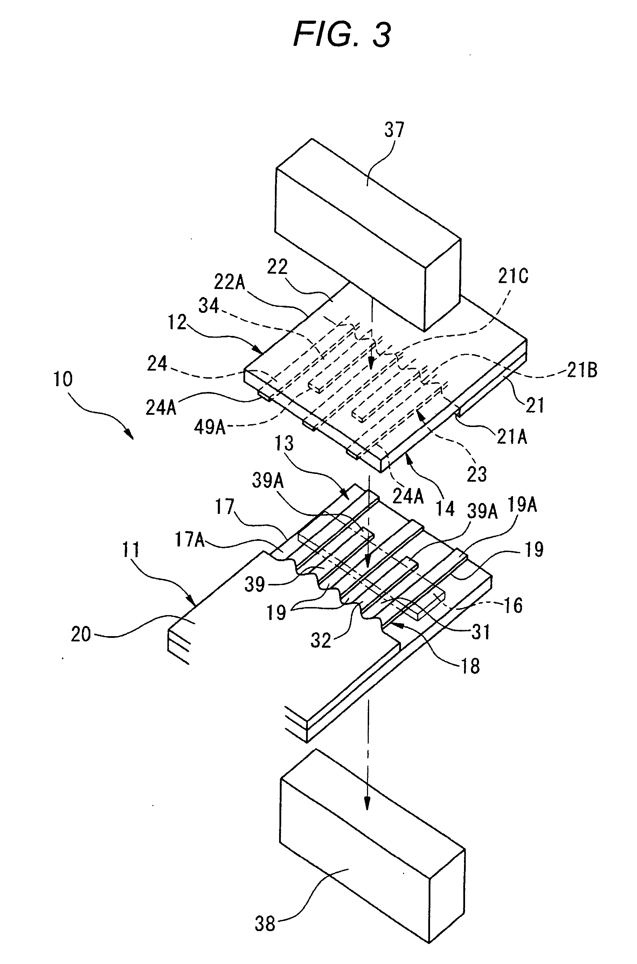

As is shown in Fig. 3, the first circuit board 11 and the second circuit board 12 are connected together by disposing the first connecting portion 13 and the second connecting portion 14 so as to confront each other with the anisotropic conductive adhesive 16 interposed therebetween and then, applying a pressure in a direction in which the first base member 17 and the second base member 22 approach each other along a thickness direction while heating the first base member 17 and the second base member 22 individually.

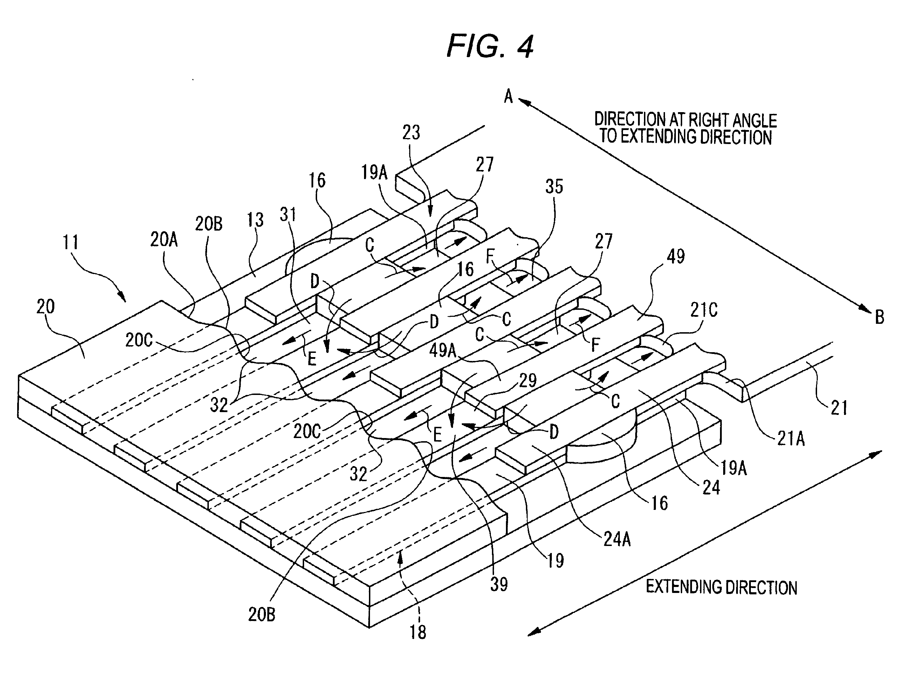

Here, the side of the first circuit board 11 which faces the first end portions 19A of the first wiring patterns of the first base member and the first end portions 39A of the second wiring patterns of the first base member is disposed into the irregular shape.
Consequently, a redundant portion of the anisotropic conductive adhesive 16 lying between the first wiring patterns 19 of the first base member and the second wiring patterns 39 of the first base member flows round to first end portion side discharge spaces 27 (refer to Fig. 4) which are formed at the first end portion 39 sides of the short second wiring patterns of the first base member which correspond to recesses.

Further, the side of the second circuit board 12 which faces the first end portions 24A of the first wiring patterns of the second base member and the first end portions 49A of the second wiring patterns of the second base member is disposed into the irregular shape.
Consequently, the redundant portion of the anisotropic conductive adhesive 16 lying between the first wiring patterns 24 of the second base member and the second wiring patterns 49 of the second base member flows round to first end portion side discharge spaces 29 (refer to Fig. 4) which are formed at the first end portion 49A sides of the short second wiring patterns of the second base member which correspond to recesses.

In addition, as is shown in Fig. 4, in the first circuit board 11, a first edge portion 20A of the first protection layer 21 which configures a boundary relative to the first connecting portion 13 has a substantially sinuous shape in which the first edge portion projects along the direction in which the first wiring patterns 19 of the first base member extend while being stacked on the first wiring patterns 19 of the first base member and projects along the direction in which the second wiring patterns 39 of the first base member extend while being stacked on the second wiring patterns 39 of the first base member.

The first edge portion 20A has portions 20B which extend along the direction in which the first wiring patterns 19 of the first base member extend and project towards the first end portions 19A of the first wiring patterns of the first base member and portions 20B which extend in the direction in which the second wiring patterns 39 of the first base member extend and project towards the first end portions 39A (refer to Fig. 2) of the second wiring patterns of the first base member.

Further, the first edge portion 20A has portions 20C which extend in a direction in which voids 31 between the first wiring patterns 19 of the first base member and the second wiring patterns 39 of the first base member extend and project in a direction in which they move away from the first end portions 19A of the first wiring patterns of the first base member and the first end portions 39A of the second wiring patterns of the first base member.

In this way, since the edge portion 20A of the first protection layer 20 has the substantially sinuous shape, the edge portion 20A can form first edge portion discharge spaces 32 for discharging the redundant portion of the anisotropic conductive adhesive.

As is shown in Fig. 3, the second circuit board 12 has, as with the first circuit board 11, a second edge portion 21A which configures a boundary of the second protection layer 21 relative to the second connecting portion.
The second edge portion 21 A has portions 21B which extend along the direction in which the first wiring patterns 24 of the second base member extend and project towards the first end portions 24A of the first wiring patterns of the second base member and portions 21 B which extend along the direction in which the second wiring patterns 49 of the second base member extend and project towards the first end portions 49A of the second wiring patterns of the second base member.

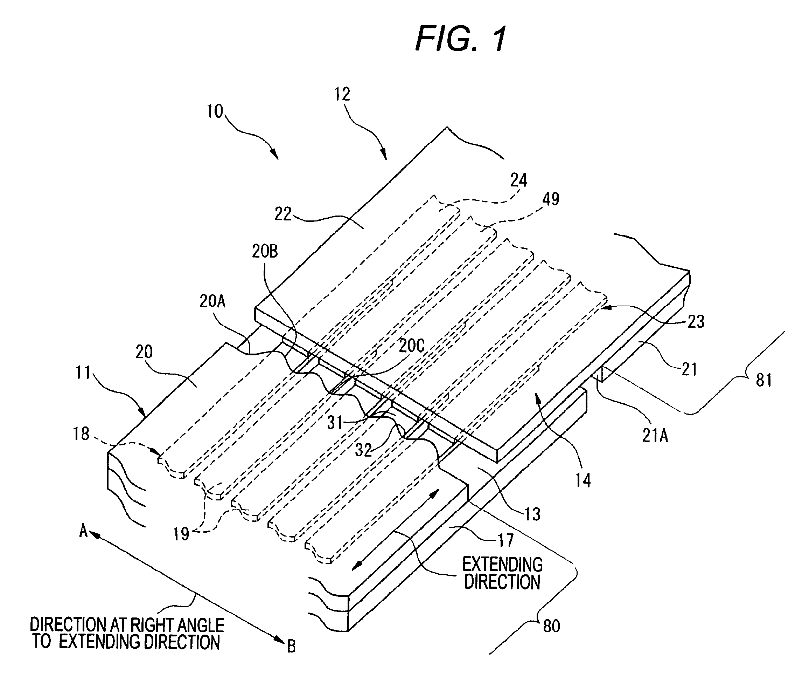

Further, the second edge portion 21A has portions 21C which extend along a direction in which voids 31 (refer to Fig. 1) between the first wiring patterns 24 of the second base member and the second wiring patterns 49 of the second base member extend and project in a direction in which they move away from the first end portions 24A of the first wiring patterns of the second base member and the first end portions 49A of the second wiring patterns of the second base member.

In this way, since the edge portion 21 A of the second protection layer 21 has the substantially sinuous shape, the edge portion 21A can form second edge portion discharge spaces 35 (also refer to Fig. 4) for discharging the redundant portion of the anisotropic conductive adhesive 16.

Here, as the substantially sinuous shape, for example, wavy shapes or sharp zigzag shapes apply thereto.

### (Modified Example)

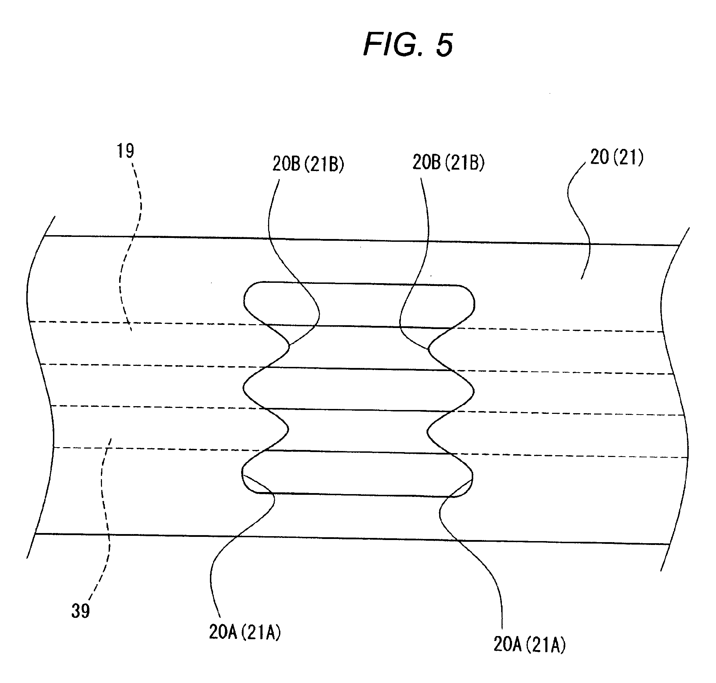

As is shown by a modified example in Fig. 5, it becomes possible to form confronting edge portions 20A of a first protection layer 20 into substantially sinuous shapes or to form confronting edge portions 21A of a second protection layer 21 are formed into substantially sinuous shapes.

Next, an example of connecting together the first connecting portion 13 and the second connecting portion 14 of the circuit board connection structure 10 of the first illustrative example will be described based on Figs. 3 to 4.
As is shown in Fig. 3, the first connecting portion 13 of the first circuit board 11 and the second connecting portion 14 of the second circuit board 12 are disposed so as to confront each other with the anisotropic conductive adhesive interposed therebetween.
In such a state that the second base member 22 is heated by an upper jig 37 and the first base member 17 is heated by a lower jig 38, a pressure is applied in such a manner that the first base member 17 and the second base member 22 approach each other along a thickness direction.

By applying the pressure in such a manner that the first base member 17 and the second base member 22 approach each other along the thickness direction, the pressure is applied to the anisotropic conductive adhesive 16.
By applying the pressure to the anisotropic conductive adhesive 16, as is shown in Fig. 4, the anisotropic conductive adhesive 16 is discharged into the first end portion side discharge spaces 27 as indicated by arrows C, and the anisotropic conductive adhesive 16 is discharged into the second end portion side discharge spaces 29 as indicated by arrows D.

Similarly, by applying the pressure to the anisotropic conductive adhesive 16, the anisotropic conductive adhesive 16 is discharged into the first edge portion discharge spaces 32 as indicated by arrows E, and the anisotropic conductive adhesive 16 is discharged into the second edge portion discharge spaces 35 as indicated by arrows F.

Consequently, the anisotropic conductive adhesive 16 can be discharged into the first end portion side discharge spaces 27, the second end portions side discharge spaces 29, the first edge portion discharge spaces 31 and the second edge portion discharge spaces 35 by desired amounts.
By this configuration, the anisotropic conductive adhesive 16 is preferably held back in the first connecting portion 13A and the second connecting portion 14A (refer to Fig. 3), so that the first connecting portion 13A and the second connecting portion 14A can be connected together well.

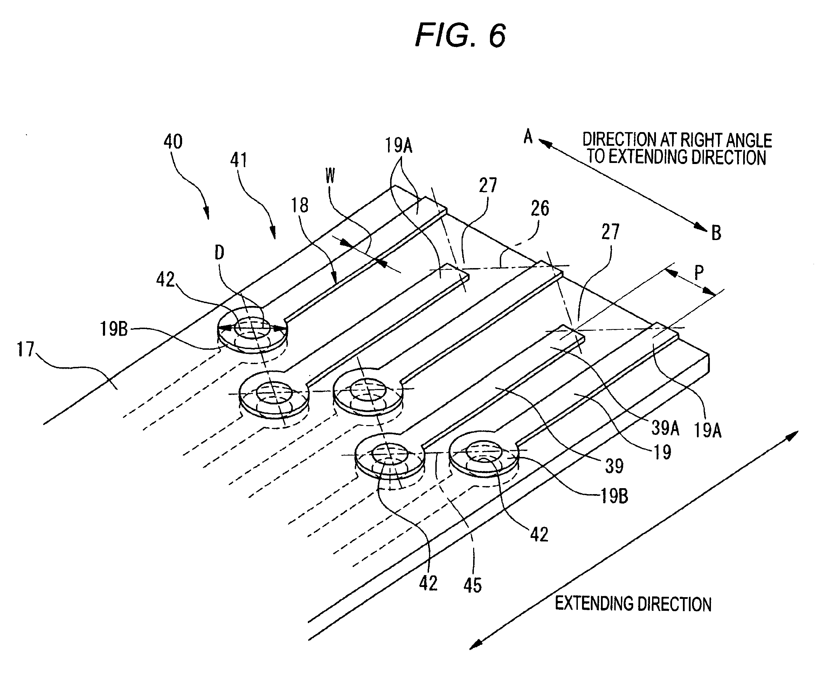

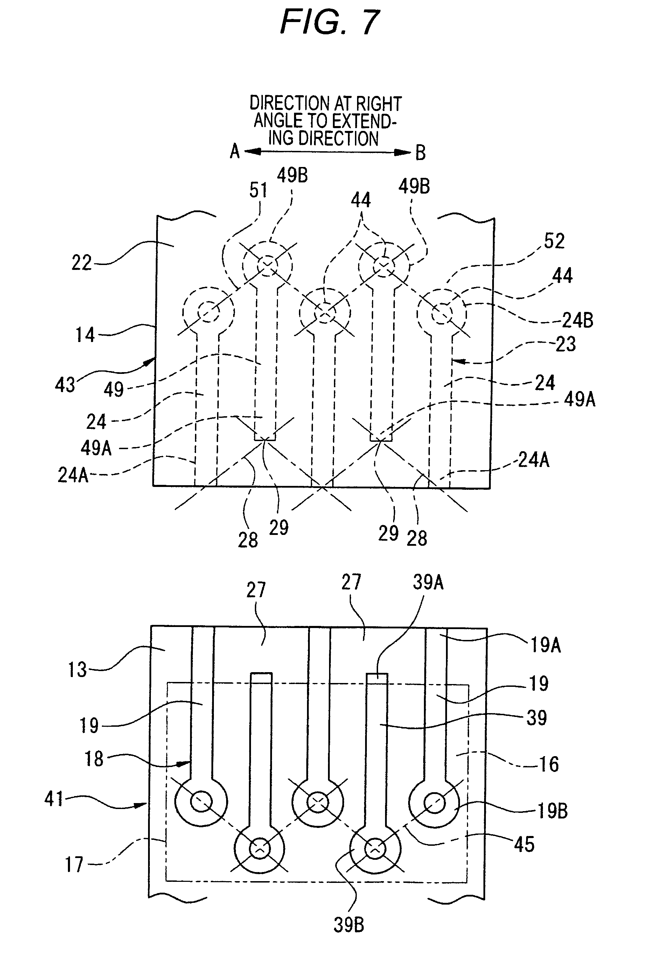

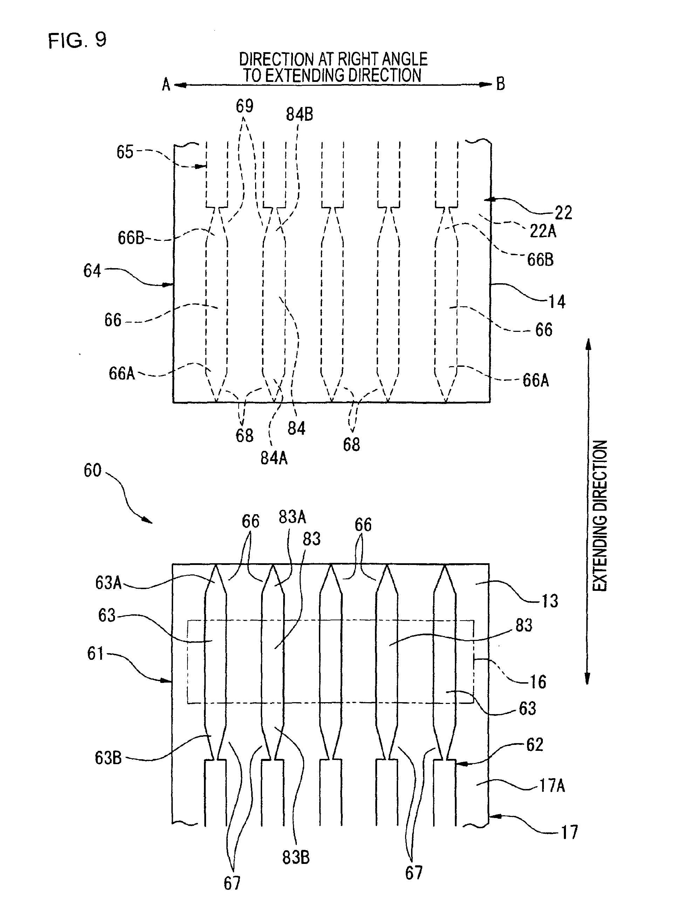

Next, a second illustrative example and an embodiment will be described based on Figs. 6 to 10. In addition, like reference numerals will be given to like members to those of the circuit board connection structure 10 of the first illustrative example to thereby omit the description thereof.

As is shown in Figs. 6 to 7, a circuit board connection structure 40 according to a second illustrative example not forming a part of the invention has, in a first circuit board (a circuit board) 41, second end portions 19B of first wiring patterns 19 of a first base member which are distal end portions which lie at opposite sides to first end portions 19A of the first wiring patterns of the first base member in a direction in which the first wiring patterns of the first base member extend and second end portions 39B of second wiring patterns 39 of the first base member which are distal end portions which lie at opposite sides to first end portions 39A of the second wiring patterns of the first base member in a direction in which the second wiring patterns 39 of the first base member extend In addition, the circuit board connection structure 40 also has, in a second circuit board (a circuit board) 43, second end portions 24B of first wiring patterns 24 of a second base member which are distal end portions which lie at opposite sides to first end portions 24A of the first wiring patterns of the second base member in a direction in which the first wiring patterns of the second base member extend and second end portions 49B of second wiring patterns 49 of the second base member which are distal end portions which lie at opposite sides to first wiring patterns 49A of the second wiring patterns of the second base member in a direction in which the second wiring patterns of the second material extend.

In the first circuit board 41, the second end portions 19B of the first wiring patterns of the first base member are connected to first vias 42 which penetrate through the first base member 17, and the second end portions 39B of the second wiring patterns of the first base member are connected to first vias 42 which penetrate through the first base member 17.

In addition, in the second circuit board 43, the second end portions 24B of the first wiring patterns of the second base member are connected to second vias 44 which penetrate through the second base member 22, and the second end portions 49B of the second wiring patterns of the second base member are connected to second vias 44 which penetrate through the second base member 22. The other configurations are the same as those of the circuit board connection structure 10 of the first illustrative example.

The first vias 42 and the second vias 44 are conductors which are formed into cylindrical shapes by forming through holes which penetrate through the first base member 17 and the second base member 22 and introducing solder into inner walls of the respective through holes.
By the provision of the first vias 42, a circuit pattern 18 formed on one side of the first base member 17 is connected to a circuit board (not shown) formed on the other side of the first base member 17.
By the provision of the second vias 44, a circuit pattern 23 formed on one side of the second base member 22 is connected to a circuit pattern (not shown) formed on the other side of the second base member 22.

The second end portions 19B of the first wiring patterns of the first base member and the second end portions 39B of the second wiring patterns of the first base member are connected to the circular first vias 42 which penetrate through the first base member 17 and have a diameter D.
The diameter D is larger than a pattern width W of the first wiring pattern 19. Namely, the second end portion 19B of the first wiring pattern of the first base member and the second end portion 39B of the second wiring pattern of the first base member are made wider than the other portions of the first wiring pattern 19, which can be an obstacle to arranging the first wiring patterns 19 of the first base member and the second wiring patterns 39 of the first base member at narrow intervals.

Then, in order to narrow intervals (pitches) between the first wiring patterns 19 of the first base member and the second wiring patterns 39 of the first base member, the second end portions 19B of the first wiring patterns of the first base member and the second end portions 39B of the second wiring patterns of the first base member are disposed in a zigzag fashion along lines 45 which intersect a direction (an A-B direction indicated by arrows A, B) which is at right angles to the direction in which the first wiring patterns 19 of the first base member extend or the direction in which the second wiring patterns 39 of the first base member extend at right angles.

Namely, the lines 45 which connect the second end portions 19B of the first wiring patterns of the first base member with the second end portions 39B of the second wiring patterns of the first base member are made to intersect the direction in which the first wiring patterns 19 of the first base member extend or the direction in which the second wiring patterns 39 of the first base member extend at a predetermined angle other than a right angle.

By this configuration, the first wiring patterns 19 of the first base member and the second wiring patterns 39 of the first base member can be arranged at narrow intervals, and a side of the first circuit board which lies to face the first end portions 19A of the first wiring patterns of the first base member and the first end portions 39A of the second wiring patterns of the first base member is disposed into an irregular shape, whereby first end portion side discharge spaces 27 can be formed.

In addition, the second end portion 24B of the first wiring patterns of the second base member and the second end portions 49B of the second wiring patterns of the second base member are connected to the second vias 44 which penetrate through the second base member 22. Because of this, as with the second end portions 19B of the fust wiring pattern of the first base member and the second end portions 39B of the second wiring patterns of the first base member, the second end portions 24B of the first wiring patterns of the second base member and the second end portions 49B of the second wiring patterns of the second base member are disposed in a zigzag fashion along a direction (an A-B direction indicated by arrows A, B) which is at right angles to the direction in which the first wiring patterns 24 of the second material extend or the direction in which the second wiring patterns 49 of the second base member extend.

Namely, the lines 51 which connect the second end portions 24B of the first wiring patterns of the second base member with the second end portions 49B of the second wiring patterns of the second base member are made to intersect the direction in which the first wiring patterns 24 of the second base member extend or the direction in which the second wiring patterns 49 of the second base member extend at a predetermined angle other than a right angle.
By this configuration, the first wiring patterns 24 of the second base member and the second wiring patterns 49 of the second base member can be arranged at narrow intervals, and a side of the second circuit pattern which lies to face the first end portions 24A of the first wiring patterns of the second base member and the first end portions 49A of the second wiring patterns of the second base member is disposed into an irregular shape, whereby second end portion side discharge spaces 29 can be formed.

When connecting the circuit board connection structure 40 of the second illustrative example, the first connecting portion 13A of the first circuit board 41 and the second connecting portion 14A of the second circuit board 43 are disposed so as to face each other with an anisotropic conductive adhesive 16 interposed therebetween.
In such a state that the first base member 17 and the second base member 22 are being heated, a pressure is applied to the first base member 17 and the second base member 22 in a direction in which the first base member 17 and the second base member 22 approach each other along a thickness direction.

By applying the pressure to the first base member 17 and the second base member 22 in the direction in which they approach each other along the thickness direction, the pressure is applied to the anisotropic conductive adhesive 16.
By applying the pressure to the anisotropic conductive adhesive 16, the anisotropic conductive adhesive 16 is discharged to the first end portion side discharge spaces 27 and the second end portion side discharge spaces 29, and the anisotropic conductive adhesive 16 is discharged into the first vias 42 and the second vias 44.

By this configuration, the anisotropic conductive adhesive 16 is allowed to be discharged well by a desired amount, and the anisotropic conductive adhesive 16 is preferably held back at the first connecting portion 13 and the second connecting portion 14, thereby making it possible to connect the first connecting portion 13 and the second connecting portion 14 together well.

Thus, as has been described heretofore, according to the circuit board connection structure 40 according to the second illustrative example, the same advantage as that of the circuit board connection structure 10 of the first illustrative example can be obtained.

### (Embodiment)

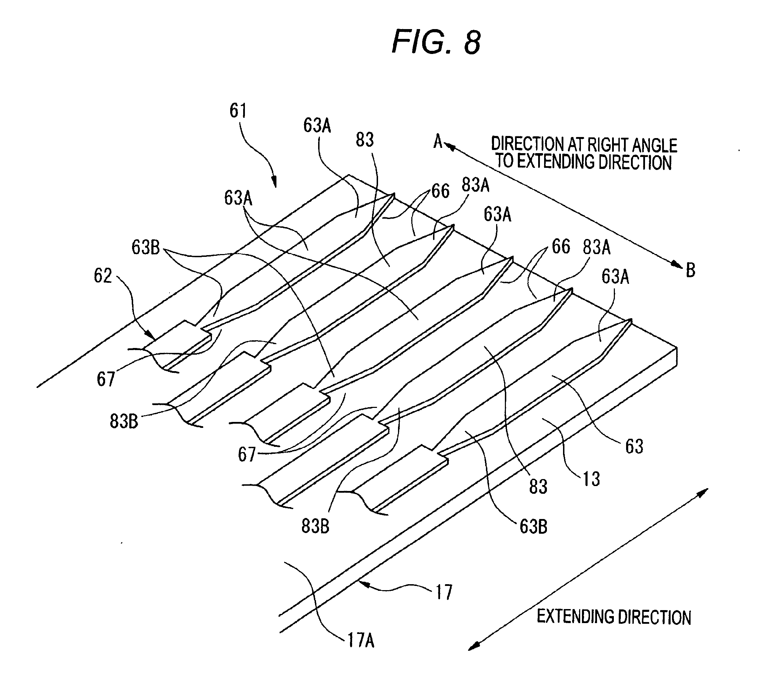

As is shown in Figs. 8 to 9, a circuit board connection structure 60 according to an embodiment has, in a first circuit board (a circuit board) 61, a first circuit pattern (a circuit pattern) 62 which is made up of first wiring patterns 63 of a first base member 17 which extend on a surface 17A of the first base member and second wiring patterns 83 of the first base member which extend substantially parallel to the first wiring patterns 63 of the first base member on the surface 17A of the first base member 17 and has, in a second circuit board 64, a second circuit pattern (a circuit pattern) 65 which is made up of first wiring patterns 66 of a second base member 22 which extend on a surface 22A of the second base member and second wiring patterns 84 of the first base member which extend substantially parallel to the first wiring patterns 66 of the second base member on the surface 22A of the second base member 22.

The first circuit board 61 has first end portions 63A of the first wiring patterns of the first base member which are distal end portions in the direction in which the first wiring patterns 63 of the first base member extend, second end portions 63B of the first wiring patterns of the first base member which are distal end portions which lie at opposite sides to the first end portions 63A of the first wiring patterns of the first base member in the direction in which the first wiring patterns 63 of the first base member extend, first end portions 83A of the second wiring patterns of the first base member which are distal end portions in the direction in which the second wiring patterns 83 of the first base member extend, and second end portions 83B of the second wiring patterns of the first base member which are distal end portions at opposite sides to the first end portions 83A of the second wiring patterns of the first base member in the direction in which the second wiring patterns 83 of the first base member extend.

The first end portions 63A of the first wiring patterns of the first base member and the second end portions 63B of the first wiring patterns of the first base member are both formed so as to be tapered in a direction in which the end portions 63A, 63B move away from each other (to be tapered as a tip of a sword does).
The first end portions 83A of the second wiring patterns of the first base member and the second end portions 83B of the second wiring patterns of the first base member are both formed so as to be tapered in a direction in which the end portions 83A, 83B move away from each other (to be tapered as a tip of a sword does).

The second circuit board 64 has first end portions 66A of the first wiring patterns of the first base member which are distal end portions in the direction in which the first wiring patterns 66 of the second base member extend, second end portions 66B of the first wiring patterns of the first base member which are distal end portions which lie at opposite sides to the first end portions 66A of the first wiring patterns of the first base member in the direction in which the first wiring patterns 66 of the first base member extend, first end portions 84A of the second wiring patterns of the first base member which are distal end portions in the direction in which the second wiring patterns 84 of the first base member extend, and second end portions 84B of the second wiring patterns of the first base member which are distal end portions at opposite sides to the first end portions 84A of the second wiring patterns of the first base member in the direction in which the second wiring patterns 84 of the first base member extend.

The first end portions 66A of the second wiring patterns of the second base member and the second end portions 66B of the first wring patterns of the second base member are both formed so as to be tapered in a direction in which the end portions 66A, 66B move away from each other (to be tapered as a tip of a sword does).
The first end portions 84A of the second wiring patterns of the second base member and the second end portions 83B of the second wiring patterns of the second base member are both formed so as to be tapered in a direction in which the end portions 84A, 84B move away from each other (to be tapered as a tip of a sword does).

The other configurations of this circuit board connection structure 60 are made similar to those of the circuit board connection structure 10 of the first illustrative example.

By forming the first end portions 63A of the first wiring patterns of the first base member so as to be tapered and forming the first end portions 83A of the second wiring patterns of the first base member so as to be tapered, first end portion side discharge spaces 66 into which an anisotropic conductive adhesive 16 is to be discharged can be formed at the first end portions 63A of the first wiring patterns of the fust base member and the first end portions 83A of the second wiring patterns of the first base member.

In addition, by forming the second end portions 63B of the first wiring patterns of the first base member so as to be tapered and forming the second end portions 83B of the second wiring patterns of the first base member so as to be tapered, first proximal end side discharge spaces 67 into which an anisotropic conductive adhesive 16 is to be discharged can be formed at the second end portions 63B of the first wiring patterns of the first base member and the second end portions 83B of the second wiring patterns of the first base member.

Further, by forming the first end portions 66A of the first wiring patterns of the second base member so as to be tapered and forming the first end portions 84A of the second wiring patterns of the second base member so as to be tapered, first end portion side discharge spaces 68 into which an anisotropic conductive adhesive 16 is to be discharged can be formed at the first end portions 66A of the first wiring patterns of the second base member and the first end portions 84A of the second wiring patterns of the second base member.

In addition, by forming the second end portions 66B of the first wiring patterns of the second base member so as to be tapered and forming the second end portions 84B of the second wiring patterns of the second base member so as to be tapered, first proximal end side discharge spaces 69 into which an anisotropic conductive adhesive 16 is to be discharged can be formed at the second end portions 66B of the first wiring patterns of the second base member and the second end portions 84B of the second wiring patterns of the second base member.

When connecting the circuit board connection structure 60 of the embodiment, a first connecting portion. 13 of the first circuit board 61 and a second connecting portion 14 of the second circuit board 64 are disposed so as to confront each other with an anisotropic conductive adhesive 16 interposed therebetween.
In such a state that the first base member 17 and the second base member 22 are being heated, a pressure is applied to the first base member 17 and the second base member 22 in a direction in which the first base member 17 and the second base member 22 approach each other along a thickness direction.

By applying the pressure to the first base member 17 and the second base member in the direction in which they approach each other along the thickness direction, the pressure is applied to the anisotropic conductive adhesive 16.
By applying the pressure to the anisotropic conductive adhesive 16, the anisotropic conductive adhesive 16 is discharged into the first end portion side discharge spaces 66, the second end portion side discharge spaces 68, the first proximal end side discharge spaces 67 and the second proximal end side discharge spaces 69.

By this configuration, the anisotropic conductive adhesive 16 is allowed to be discharged well by a desired amount, and the anisotropic conductive adhesive 16 is preferably held back at the first connecting portion 13 and the second connecting portion 14, thereby making it possible to connect the first connecting portion 13 and the second connecting portion 14 together well.

Thus, as has been described heretofore, according to the circuit board connection structure 60 according to the embodiment, the same advantage as that of the circuit board connection structure 10 according to the first illustrative example can be obtained.

### (Modified Example of the Invention)

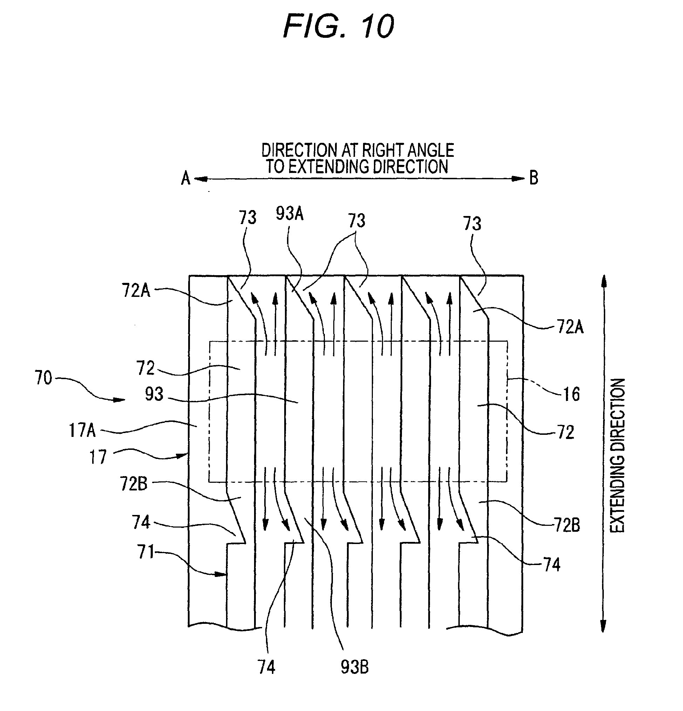

While the circuit board connection structure 60 according to the embodiment has been described as the first end portions 63A of the first wiring patterns of the first base member and the second end portions 63B of the first wiring patterns of the first base member being formed so as to be tapered as the tip of a sword does and the first end portions 83A of the second wiring patterns of the first base member and the second end portions 83B of the second wiring patterns of the first base member being formed so as to be tapered as the tip of a sword does, the invention is not limited thereto. As is shown in Fig. 10, each of the end portions can also be formed so as to be tapered by forming only one side of the end portion into an oblique shape (into a tapered shape).

Namely, a first circuit board (a circuit board) 70 of a modified example shown in Fig. 10 has a first circuit pattern (a circuit pattern) 71 which is made up of first wiring patterns 72 of a first base member 17 which extend on a surface 17A of the first base member and second wiring patterns 93 of the first base member which extend substantially parallel to the first wiring patterns 72 of the first base member on the surface 17A of the first base member 17.

The first circuit board 70 has first end portions 72A of the first wiring patterns of the first base member which are distal end portions in the direction in which the first wiring patterns of the first base member extend and second end portions 72B of the first wiring patterns of the first base member which are distal end portions which lie at opposite sides to the first end portions 72A of the first wiring patterns of the first base member.
Further, the first circuit board 70 has first end portions 93A of the second wiring patterns 93 of the first base member which are distal end portions in the direction in which the second wiring patterns 93 of the first base member extend and second end portions 93B of the second wiring patterns of the first base member which are distal end portions which lie at opposite sides to the first end portions 89A of the second wiring patterns of the first base member in the direction in which the second wiring patterns 93 of the first base member extend.

The first end portions 72A of the first wiring patterns of the first base member and the second end portions 72B of the first wiring patterns of the first base member are both formed so as to be tapered in a direction in which the end portions 72A, 72B move away from each other (to be tapered in such a way that only one side of the end portion is formed into an oblique fashion).
The first end portions 93A of the second wiring patterns of the first base member and the second end portions 93B of the second wiring patterns of the first base member are both formed so as to be tapered in a direction in which the end portions 93A, 93B move away from each other (to be tapered in such a way that only one side of the end portion is formed into an oblique fashion).

By forming the first end portions 72A of the first base member so as to be tapered and forming the first end portions 93A of the second wiring patterns of the first base member, first end portion side discharge spaces 73 into which an anisotropic conductive adhesive 16 is to be discharged can be formed at the first end portions 72A of the first wiring patterns of the first base member and the first end portions 93A of the second wiring patterns of the first base member.

By forming the second end portions 72B of the first base member so as to be tapered and forming the second end portions 93B of the second wiring patterns of the first base member, first end portion side discharge spaces 74 into which an anisotropic conductive adhesive 16 is to be discharged can be formed at the second end portions 72B of the first wiring patterns of the first base member and the second end portions 93B of the second wiring patterns of the first base member.

According to the first circuit board 70 of the modified example of the invention, the anisotropic conductive adhesive 16 can be discharged well into the first end portion side discharge spaces 73 and the first proximal portion side discharge spaces 74.
As has been described heretofore, according to the first circuit board 70 of the modified example, the same advantage as that of the circuit board connection structure 60 according to the embodiment can be obtained.

### Industrial Applicability

The invention is preferably applied to a circuit board in which a circuit pattern is formed on a surface of a base member and a protection layer is laminated in such a manner that a connecting portion provided at an end portion of the circuit pattern is exposed and a circuit board connection structure in which such circuit boards are connected together via an anisotropic conductive adhesive.

## Claims

1. A circuit board (61) comprising:
a base member (17);
a circuit pattern (62) including a first wiring pattern (63) which extends on a surface (17A) of the base member (17) and a second wiring pattern (83) which extends substantially parallel to the first wiring pattern (63) on the surface (17A) of the base member (17); and
a connecting portion (13) provided at one end portion of the circuit pattern (62) for connecting the circuit board (61) to another circuit board via an anisotropic conductive adhesive, and having:
a first end portion (63A) of the first wiring pattern (63) which is a distal end portion in a direction in which the first wiring pattern (63) extends;
a second end portion (63B)of the first wiring pattern (63) which is a distal end portion which lies at an opposite side to the first end portion (63A) of the first wiring pattern in the direction in which the first wiring pattern (63) extends;
a first end portion (83A) of the second wiring pattern (83) which is a distal end portion in a direction in which the second wiring pattern (83) extends; and
a second end portion (83B) of the second wiring pattern (83) which is a distal end portion which lies at an opposite side to the first end portion (83A) of the second wiring pattern (83) in the direction in which the second wiring pattern (83) extends, wherein either the first end portion (63A) of the first wiring pattern or the second end portion (638) of the first wiring pattern is formed so as to be tapered in a direction in which either the first end portion (63A) or the second end portion (63B) points away from the other.

2. A circuit board connection structure comprising:
a first circuit board (61) including:
a first base member (17);
a first circuit pattern (62) having a first wiring pattern (63) of the first base member (17) which extends on a surface (17A) of the first base member (17) and a second wiring pattern (83) of the first base member (17) which extends substantially parallel to the first wiring pattern (63) of the first base member (17) on the surface (17A) of the first base member (17); and
a first connecting portion (13) provided at one end portion of the first circuit pattern (62) and having:
a first end portion (63A) of the first wiring pattern (63) of the first base member (17) which are a distal end portion in a direction in which the first wiring pattern (63) of the first base member (17) extends;
a second end portion (63B) of the first wiring pattern (63) of the first base member (17) which is a distal end portion which lies at an opposite side to the first end portion (63A) of the first wiring pattern (63) of the first base member (17) in the direction in which the first wiring pattern (63) extends;
a first end portion (83A) of the second wiring pattern (83) of the first base member (17) which is a distal end portion in a direction in which the second wiring pattern (83) of the first base member (17) extends; and
a second end portion (83B) of the second wiring pattern (83) of the first base member (17) which is a distal end portion which lies at an opposite side to the first end portion (83A) of the second wiring pattern (83) of the first base member (17) in the direction in which the second wiring pattern (83) extends; and
a second circuit board (64) including:
a second connecting portion (14) having a second circuit pattern (65) provided with a first wiring pattern (66) of a second base member (22) which extends on a surface (22A) of the second base member (22) and a second wiring pattern (84) which extends substantially parallel to the first wiring pattern (66) of the second base member (22) on the surface (22A) of the second base member (22), the second connecting portion (14) being provided at one end portion of the second circuit pattern (65),
wherein the first connecting portion (13) and the second connecting portion (14) are disposed so as to confront each other, so that the first wiring pattern (63) of the first base member (17) of the first connecting portion (13) and the first wiring pattern (66) of the second base member (22) of the second connecting portion (14) are connected together and the second wiring pattern (83) of the first base member (17) of the first connecting portion (13) and the second wiring pattern (84) of the second base member (22) of the second connecting portion (14) are connected together via an anisotropic conductive adhesive (16), wherein either the first end portion (63A) of the first wiring pattern (63) of the first base member (17) or the second end portion (63B) of the first wiring pattern (63) of the first base member (17) is formed so as to be tapered in a direction in which either the first end portion (63A) or the second end portion (63B) points away from the other.

## Patentansprüche

1. Leiterplatte (61), die umfasst:
ein Trägerelement (17);
ein Schaltungsmuster (62), das ein erstes Verdrahtungsmuster (63), das an einer Oberfläche (17A) des Trägerelementes (17) verläuft, und ein zweites Verdrahtungsmuster (83) enthält, das im Wesentlichen parallel zu dem ersten Verdrahtungsmuster (63) an der Oberfläche (17A) des Trägerelementes (17) verläuft; und
einen Verbindungsabschnitt (13), der an einem Endabschnitt des Schaltungsmusters (62) vorhanden ist, um die Leiterplatte (61) über einen anisotropen leitenden Klebstoff mit einer anderen Leiterplatte zu verbinden, wobei er aufweiset:
einen ersten Endabschnitt (63A) des ersten Verdrahtungsmusters (63), der ein vorderer Endabschnitt in einer Richtung ist, in der das erste Verdrahtungsmuster (63) verläuft;
einen zweiten Endabschnitt (63B) des ersten Verdrahtungsmusters (63), der in der Richtung, in der das erste Verdrahtungsmuster (63) verläuft, ein vorderer Endabschnitt ist, der an einer dem ersten Endabschnitt (63A) des ersten Verdrahtungsmusters gegenüberliegenden Seite liegt;
einen ersten Endabschnitt (83A) des zweiten Verdrahtungsmusters (83), der in einer Richtung, in der das zweite Verdrahtungsmuster (83) verläuft, ein vorderer Endabschnitt ist;
und
einen zweiten Endabschnitt (83B) des zweiten Verdrahtungsmusters (83), der in der Richtung, in der das zweite Verdrahtungsmuster (83) verläuft, ein vorderer Endabschnitt ist, der an einer dem ersten Endabschnitt (83A) des zweiten Verdrahtungsmusters (83) gegenüberliegenden Seite liegt, wobei entweder der erste Endabschnitt (63A) des ersten Verdrahtungsmusters oder der zweite Endabschnitt (63B) des ersten Verdrahtungsmusters so ausgebildet ist, dass er sich in einer Richtung verjüngt, in der entweder der erste Endabschnitt (63A) oder der zweite Endabschnitt (63B) von dem jeweils anderen weg gerichtet ist.

2. Leiterplatten-Verbindungsstruktur, die umfasst:
eine erste Leiterplatte (61), die enthält:
ein erstes Trägerelement (17);
ein erstes Schaltungsmuster (62), das ein erstes Verdrahtungsmuster (63) des ersten Trägerelementes (17), das an einer Oberfläche (17A) des ersten Trägerelementes (17) verläuft, und ein zweites Verdrahtungsmuster (83) des ersten Trägerelementes (17) aufweist,
das im Wesentlichen parallel zu dem ersten Verdrahtungsmuster (63) des ersten Trägerelementes (17) an der Oberfläche (17A) des ersten Trägerelementes (17) verläuft; und
einen ersten Verbindungsabschnitt (13), der an einem Endabschnitt des ersten Schaltungsmusters (62) vorhanden ist und aufweist:
einen ersten Endabschnitt (63A) des ersten Verdrahtungsmusters (63) des ersten Trägerelementes (17), der in einer Richtung in der das erste Verdrahtungsmuster (63) des ersten Trägerelementes (17) verläuft, ein vorderer Endabschnitt ist;
einen zweiten Endabschnitt (63B) des ersten Verdrahtungsmusters (63) des ersten Trägerelementes (17), der in der Richtung, in der das erste Verdrahtungsmuster (63) verläuft,
ein vorderer Endabschnitt ist, der an einer dem ersten Endabschnitt (63A) des ersten Verdrahtungsmusters (63) des ersten Trägerelementes (17) gegenüberliegenden Seite liegt;
einen ersten Endabschnitt (83A) des zweiten Verdrahtungsmusters (83) des ersten Trägerelementes (17), der in einer Richtung, in der das zweite Verdrahtungsmuster (83) des ersten Trägerelementes (17) verläuft, ein vorderer Endabschnitt ist; und
einen zweiten Endabschnitt (83B) des zweiten Verdrahtungsmusters (83) des ersten Trägerelementes, der in der Richtung, in der das zweite Verdrahtungsmuster (83) verläuft, ein vorderer Endabschnitt ist, der an einer dem ersten Endabschnitt (83A) des zweiten Verdrahtungsmusters (83) des ersten Trägerelementes (17) gegenüberliegenden Seite liegt; und
eine zweite Leiterplatte (64), die enthält:
einen zweiten Verbindungsabschnitt (14), der ein zweites Schaltungsmuster (65), das mit einem ersten Verdrahtungsmuster (66) eines zweiten Trägerelementes (22) versehen ist, das an einer Oberfläche (22A) des zweiten Trägerelementes (22) verläuft, und ein zweites Verdrahtungsmuster (84) aufweist, das im Wesentlichen parallel zu dem ersten Verdrahtungsmuster (66) des zweiten Trägerelementes (22) an der Oberfläche (22A) des zweiten Trägerelementes (22) verläuft, wobei der zweite Verbindungsabschnitt (14) an einem Endabschnitt des zweiten Schaltungsmusters (65) vorhanden ist,
und der erste Verbindungsabschnitt (13) sowie der zweite Verbindungsabschnitt (14) so angeordnet sind, dass sie einander gegenüberliegen, so dass das erste Verdrahtungsmuster (63) des ersten Trägerelementes (17) des ersten Verbindungsabschnitts (13) und das erste Verdrahtungsmuster (66) des zweiten Trägerelementes (22) des zweiten Verbindungsabschnitts (14) miteinander verbunden sind und das zweite Verdrahtungsmuster (83) des ersten Trägerelementes (17) des ersten Verbindungsabschnitts (13) und das zweite Verdrahtungsmuster (84) des zweiten Trägerelementes (22) des zweiten Verbindungsabschnitts (14) über einen anisotropen leitenden Klebstoff (16) miteinander verbunden sind und entweder der erste Endabschnitt (63A) des ersten Verdrahtungsmusters (63) des ersten Trägerelementes (17) oder der zweite Endabschnitt (63B) des ersten Verdrahtungsmusters (63) des ersten Trägerelementes (17) so ausgebildet ist, dass er sich in einer Richtung verjüngt, in der entweder der erste Endabschnitt (63A) oder der zweite Endabschnitt (63B) von dem jeweils anderen weg gerichtet ist.

## Revendications

1. Carte de circuit (61) comprenant :
un élément de base (17) ;
un motif de circuit (62) incluant un premier motif de câblage (63) s'étendant sur une surface (17A) de l'élément de base (17) et un second motif de câblage (83) s'étendant sensiblement parallèlement au premier motif de câblage (63) sur la surface (17A) de l'élément de base (17) ; et
une partie de connexion (13) prévue à une partie d'extrémité du motif de circuit (62) pour connecter la carte de circuit (61) à une autre carte de circuit par l'intermédiaire d'une colle conductrice anisotrope, et comportant :
une première partie d'extrémité (63A) du premier motif de câblage (63) qui est une partie d'extrémité distale dans la direction dans laquelle s'étend le premier motif de câblage (63) ;
une seconde partie d'extrémité (63B) du premier motif de câblage (63) qui est une partie d'extrémité distale disposée sur une face opposée par rapport à la première partie d'extrémité (63A) du premier motif de câblage dans la direction dans laquelle s'étend le premier motif de câblage (63) ;
une première partie d'extrémité (83A) du second motif de câblage (83) qui est une partie d'extrémité distale dans la direction dans laquelle s'étend le second motif de câblage (83) ; et
une seconde partie d'extrémité (83B) du second motif de câblage (83) qui est une partie d'extrémité distale disposée sur une face opposée par rapport à la première partie d'extrémité (83A) du second motif de câblage (83) dans la direction dans laquelle s'étend le second motif de câblage (83), dans lequel, soit la première partie d'extrémité (63a) du premier motif de câblage, soit la seconde partie d'extrémité (63B) du premier motif de câblage est formée de façon à être effilée dans la direction dans laquelle, soit la première partie d'extrémité (63A), soit la seconde partie d'extrémité (63B) sont dirigées à l'opposé l'une de l'autre.

2. Structure de connexion de cartes de circuit comprenant :
une première carte de circuit (61) incluant :
un premier élément de base (17) ;
un premier motif de circuit (62) comportant un premier motif de câblage (63) du premier élément de base (17) s'étendant sur une surface (17A) du premier élément de base (17) et un second motif de câblage (83) du premier élément de base (17) s'étendant sensiblement parallèlement au premier motif de câblage (63) du premier élément de base (17) sur la surface (17A) du premier élément de base (17) ; et
une première partie de connexion (13) prévue à une partie d'extrémité du premier motif de circuit (62) et comportant :
une première partie d'extrémité (63A) du premier motif de câblage (63) du premier élément de base (17) qui est une partie d'extrémité distale dans la direction dans laquelle s'étend le premier motif de câblage (63) du premier élément de base (17) ;
une seconde partie d'extrémité (63B) du premier motif de câblage (63) du premier élément de base (17) qui est une partie d'extrémité distale disposée sur une face opposée par rapport à la première partie d'extrémité (63A) du premier motif de câblage (63) du premier élément de base (17) dans la direction dans laquelle s'étend le premier motif de câblage (63) ;
une première partie d'extrémité (83A) du second motif de câblage (83) du premier élément de base (17) qui est une partie d'extrémité distale dans la direction dans laquelle s'étend le second motif de câblage (83) du premier élément de base (17) ; et
une seconde partie d'extrémité (83B) du second motif de câblage (83) du premier élément de base (17) qui est une partie d'extrémité distale disposée sur une face opposée par rapport à la première partie d'extrémité (83A) du second motif de câblage (83) du premier élément de base (17) dans la direction dans laquelle s'étend le second motif de câblage (83) ; et
une seconde carte de circuit (64) incluant :
une seconde partie de connexion (14) comportant un second motif de circuit (65) muni d'un premier motif de câblage (66) d'un second élément de base (22) s'étendant sur une surface (22A) du second élément de base (22) et un second motif de câblage (84) s'étendant sensiblement parallèlement au premier motif de câblage (66) du second élément de base (22) sur la surface (22A) du second élément de base (22), la seconde partie de connexion (14) étant disposée à une partie d'extrémité du second motif de circuit (65),
dans lequel la première partie de connexion (13) et la seconde partie de connexion (14) sont disposées de manière à être confrontées l'une à l'autre, de telle sorte que le premier motif de câblage (63) du premier élément de base (17) de la première partie de connexion (13) et le premier motif de câblage (66) du second élément de base (22) de la seconde partie de connexion (14) soient connectés ensemble et que le second motif de câblage (83) du premier élément de base (17) de la première partie de connexion (13) et le second motif de câblage (84) du second élément de base (22) de la seconde partie de connexion (14) soient connectés ensemble par l'intermédiaire d'une colle conductrice anisotrope (16), dans lequel, soit la première partie d'extrémité (63A) du premier motif de câblage (63) du premier élément de base (17), soit la seconde partie d'extrémité (63B) du premier motif de câblage (63) du premier élément de base (17) est formée de façon à être effilée dans la direction dans laquelle, soit la première partie d'extrémité (63A), soit la seconde partie d'extrémité (63B) sont dirigées à l'opposé l'une de l'autre.
